Europäisches Patentamt

(19) European Patent Office

Office européen des brevets

(11) Publication number: **0 144 142 B1**

## (12) EUROPEAN PATENT SPECIFICATION

(45) Date of publication of patent specification: **18.12.91**

(51) Int. Cl.⁵: **H01L 21/306, H01L 33/00**

(21) Application number: **84307339.6**

(22) Date of filing: **25.10.84**

(54) **Method of fabrication a semiconductor laser.**

(30) Priority: **30.11.83 JP 224077/83**
**28.03.84 JP 58135/84**

(43) Date of publication of application:
**12.06.85 Bulletin 85/24**

(45) Publication of the grant of the patent:
**18.12.91 Bulletin 91/51**

(84) Designated Contracting States:
**DE FR GB NL**

(56) References cited:
**DE-A- 3 132 555**

**PROCEEDINGS OF THE INTERNATIONAL SYMPOSIUM ON GALLIUM ARSENIDE AND RELATED COMPOUNDS, Vienna, AT, 22nd - 24th September 1980, pages 267-273, The Institute of Physics, Bristol/London, GB; L.A. D'ASARO et al: "Plasma-etched via connections to GaAs FET's"**

**PATENT ABSTRACTS OF JAPAN, vol. 7, no. 258 (E-211) [1403], 17th November 1983 & JP-A-58-143 530**

(73) Proprietor: **KABUSHIKI KAISHA TOSHIBA**
**72, Horikawa-cho Saiwai-ku**
**Kawasaki-shi Kanagawa-ken(JP)**

(72) Inventor: **Nagasaka, Hiroko c/o Patent Division**
**Kabushiki Kaisha Toshiba 1-1 Shibaura 1-chome**
**Minato-ku Tokyo 105(JP)**
Inventor: **Motegi, Nawoto c/o Patent Division**
**Kabushiki Kaisha Toshiba 1-1 Shibaura 1-chome**
**Minato-ku Tokyo 105(JP)**
Inventor: **Tamura, Hideo c/o Patent Division**
**Kabushiki Kaisha Toshiba 1-1 Shibaura 1-chome**
**Minato-ku Tokyo 105(JP)**

(74) Representative: **Freed, Arthur Woolf et al**
**MARKS & CLERK 57-60 Lincoln's Inn Fields**
**London WC2A 3LS(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

EXTENDED ABSTRACTS, vol. 83-1, May 1983, page 546, Pennington, New Jersey, US; D.L. FLAMM: "Plasma etching of III-V compounds"

SOLID STATE TECHNOLOGY, vol. 25, no. 4, April 1982, pages 160-165, Port Washington, New York, US; R.F. REICHELDERFER: "Single wafer plasma etching"

## Description

The present invention relates to a method of fabricating a semiconductor laser by dry etching a compound semiconductor using a plasma etching apparatus.

A III-V Group compound semiconductor such as gallium arsenide, indium phosphide, or gallium aluminum arsenide is used as a base material of a semiconductor laser. When a substrate of such a compound semiconductor is used, a semiconductor device can be manufactured such as a field effect transistor or an integrated device thereof having a better performance than that of a semiconductor device having a silicon substrate. Furthermore, by using such compound semiconductors, an "optoelectric circuit" has been developed with a new concept in which an electrical integrated circuit and a light emitting/receiving element circuit are integrally formed.

In order to improve the productivity and the reproducibility in the manufacture of semiconductor devices including such compound semiconductor devices, a dry etching method has recently been used in a manufacturing process thereof. Particularly, a reactive ion etching method using a parallel flat plate electrode type device has been suggested as a dry etching process. In this method, a plasma-generating gas containing halogen is introduced to a vacuum pressure of $10^{-2}$ to $10^{-1}$ Torr (1.33-13.3 Pa) in a vacuum chamber having an electrode (cathode) to which high-frequency power is applied and a ground electrode (anode) opposite thereto. A material to be etched is placed on the cathode. When the plasma-generating gas is introduced, the high-frequency power is applied to the cathode, thereby generating a glow discharge. Then, the cathode is negatively self-biased by a mobility difference between electrons and ions, and a dark space is formed thereon. A cathode breakdown voltage Vdc is also generated by this self bias. Reactive ions generated by the glow discharge from the plasma-generating gas are accelerated by the cathode breakdown voltage, thereby bombarding the material to be etched. Atoms sputtered by this bombardment react with the reactive ions to generate highly volatile molecules, and the molecules are discharged from the vacuum chamber. Thus, the etching is performed.

In this etching method, the material can be an isotropically etched. Under optimal conditions, a pattern width of about 0.5 to 1 $\mu$m can be obtained. Therefore, a high-density and high-performance semiconductor device can be obtained with this method in comparison to a wet etching method in which an undercut easily occurs and it is difficult to obtain micropatterning. However, although the dry etching method is effective in manufacturing a semiconductor device as described above, it has the problems to be described below when this method is used to etch a compound semiconductor unlike a single semiconductor material such as silicon, or metallic material such as aluminum. So, the dry etching method has not been used practically to etch compound semiconductors.

In a compound semiconductor, since this material consists of a plurality of different types of atoms, conditions for simultaneously etching those plurality of different types of atoms must be selected. Further, etching mechanism of the compound semiconductors is very complicated and is not known to a satisfactory extent.

In a manufacturing process of a semiconductor laser, in order to form an end face of a resonator or a mesa structure, an etching depth of about 5 $\mu$m is required. In comparison to a prior art technique which needs an etching dept of 1 $\mu$m or less, an etching rate and an etching selectivity with respect to a mask must be several times those of the prior art. Therefore, the prior art technique and the conditions thereof cannot be adopted. The use of $BCl_3$ and $Cl_2$ as an etching gas for GaAs also is known (Proc. Int. Symp. "Gallium Arsenide and related compounds 1980", Inst. Phys. Cont. Sev. No. 36, Chap. 5, pp. 267-273).

$CCl_2F_2$ or $Cl_2$ gas is known as a reactive ion etching gas for GaAs. However, the present inventors confirmed by experiment that a GaAlAs crystal surface, the protection layer and the GaAlAs layer could be etched using $Cl_2$ gas. However, such a protection layer adds another requirement for device design, and has an etching rate too low under anisotropic etching conditions. Therefore, such a protection layer cannot be used in a device manufacturing process.

The present inventors experimentally confirmed that when GaAlAs was etched by using $CCl_4$ gas, an etching rate was too low and reproducibility was very poor.

The present inventors also experimentally confirmed that when a GaAlAs layer was etched using a gas mixture of $Cl_2$ and $CCl_4$, it was etched at an etching rate which was suitable for a device manufacturing process. Despite this, the present inventors found that proper etching could not be achieved by using the above-mentioned gas mixture for the following reasons.

a) Since a proper etching rate can be obtained within a limited etching condition range, the proper etching rate cannot always be achieved due to variations in etching devices or different environmental factors.

b) This method has poor reproducibility. Since both the $CCl_4$ and $Cl_2$ gases cannot effectively

3

scavenge $H_2O$, $O_2$ and the like, Al reacts with $O_2$ included in an etching atmosphere and $H_2O$ is adsorbed in $AlCl_3$ as a reaction product, resulting in poor evacuation. Therefore, an etching rate and etching characteristics thereof are easily changed by differences in the evacuation condition of $H_2$ is adsorbed in $AlCl_3$ as a reaction product, resulting in poor evacuation. Therefore, an etching rate and etching characteristics thereof are easily changed by differences in the evacuation condition of $H_2O$, $O_2$ and the like, reaction products, the evacuation efficiency of residues and the temperature of the electrodes.

c) An etching selectivity ratio of the compound semiconductor with respect to a mask cannot be set at a high value; it is 5 to 10 at most. This results from sputter of a mask since the ion bombardment effect of the gas it too large.

d) A polymer is formed on the surface of the etching material which is etched. This polymer partially serves as a mask with respect to the surface of the material, thereby blocking etching and complicating removal of this polymer after the etching.

According to the invention there is provided a method of a compound semiconductor comprising the steps of:

introducing a plasma-generating gas into a plasma generation region which is defined between a cathode supporting a workpiece comprising a compound semiconductor and an anode opposite thereto;

applying high-frequency electric power between said cathode and said anode, thereby generating a plasma from said plasma-generating gas; and

etching said compound semiconductor with said plasma;

characterised in that the said plasma-generating gas comprises boron trichloride and chlorine and that said compound semiconductor is formed on a GaAs substrate and is a multilayer having a plurality of GaAlAs layers respectively having different contents of aluminum.

This invention can be more fully understood from the following detailed description when taken in conjunction with the accompanying drawings, in which:

Fig. 1 is a schematic view showing an example of an etching apparatus used in a dry etching method according to an embodiment of the present invention;

Figs. 2 and 3 are graphs respectively showing the relationship between etching time and etching depth when a compound semiconductor is etched according to the method of the present invention;

Fig. 4 is a graph showing the relationship between an etching time and an etching depth when a compound semiconductor is etched using dichlorodifluoromethane;

Fig. 5 is a graph showing the relationship between a flow rate ratio of $Cl_2$ and $BCl_3$ and an etching rate when a compound semiconductor is etched according to the mehtod of the present invention;

Fig. 6 is a graph showing the relationship between a partial pressure ratio of $Cl_2$ and carbon tetrachloride ($CCl_4$) and an etching rate when a compound semiconductor is etched using a mixture of $CCl_4$ and $Cl_2$;

Fig. 7 is a graph showing the relationship between a total pressure of a plasma-generating gas and an etching rate when a compound semiconductor is etched according to the present invention;

Fig. 8 is a representation showing the uniformity of etching when a compound semiconductor is etched according to the method of the present invention;

Fig. 9 is a graph showing the uniformity of etching when a compound semiconductor is etched using dichlorodifluoromethane;

Fig. 10 is a graph showing the reproducibility when a compound semiconductor is etched according to the method of the present invention; and

Figs. 11A to 11D and 12 are respectively sectional views and a perspective view for explaining steps of manufacturing a semiconductor laser using a dry etching method of the present invention.

The present inventors discovered that factors important for etching semiconductor materials such as III-V Group compound semiconductors, particularly those comprising elements such as aluminum which are easily oxidized, are whether or not native oxide formed on a surface of a compound semiconductor can be etched by reactive ions generated from a plasma gas, and whether or not $H_2O$ molecules and $O_2$ in an etching atmosphere can be effectively removed. According to these discoveries, the present inventors have considered various plasma-generating gases and found that $BCl_3$ could be satisfactory used as a plasma-generating gas to some extent.

This is because the native oxide can be effectively removed by a plasma from $BCl_3$, and boron ions dissociated from the $BCl_3$ react with $H_2O$ molecules to form boron hydroxide and with $O_2$ to form boron trioxide. These reaction products can be effectively evacuated. In fact, it has been reported that $O_2$ contained in a plasma atmosphere in an amount up to 1% can be evacuated to an extent to be negligible after a plasma is generated. Therefore, a reaction between a component of a compound semiconductor such as aluminum, which is easily oxidized, and $O_2$ can be decreased, and adsorption of $H_2O$ by aluminum chloride formed by a reaction between chlorine ions dissociated from the $BC\ell_3$ and aluminum can also be decreased, thereby considerably improving the reproducibility.

In addition, when the $BC\ell_3$ is used, no polymer is formed on a surface of a workpiece which is subjected to etching as with $CC\ell_4$, thereby improving the reproducibility of an etching pattern and simplifying treatment steps after etching.

Furthermore, when $BC\ell_3$ is used, since bombardment of ions dissociated therefrom on the workpiece is weaker than that of $CC\ell_4$, an etching rate (etching selectivity ratio) of a compound semiconductor with respect to a mask material such as a photoresist is increased.

In this manner, it is expected that the $BC\ell_3$ can be effectively used as a plasma-generating gas for reactive ion etching. However, when the $BC\ell_3$ is used in etching, an etching rate with respect to a compound semiconductor is as low as about 0.01 $\mu$m per minute. Therefore, when deep etching is performed, the etching time is undesirably prolonged. The present inventors have made studies into the cause of this low etching rate by $BC\ell_3$ and found that the $BC\ell_3$ was dissociated with low efficiency into chlorine ions and chlorine radicals as an effective etchant of a compound semiconductor, and that the disadvantages could be overcome without losing the above-mentioned advantages by adding chlorine gas to the $BC\ell_3$, thus achieving the present invention.

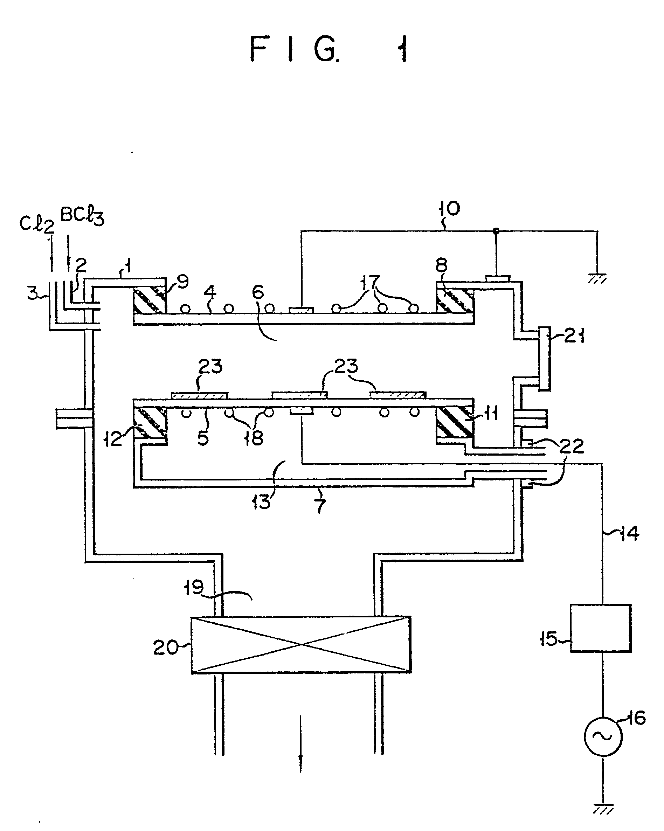

The present invention will be described in more detail with reference to Fig. 1 hereafter.

Fig. 1 schematically shows an example of an etching apparatus used for performing a dry etching method of the present invention. This apparatus comprises a vacuum chamber 1 made of, for example, stainless steel. The vacuum chamber 1 has inlet ports 2 and 3 for a plasma-generating gas. The vacuum chamber 1 has an observation window 21 at a side opposite to the inlet ports 2 and 3. A flat plate anode 4 which consists of a portion of a wall of the vacuum chamber 1 and a flat plate cathode 5 which is arranged parallel and opposite thereto are disposed in the vacuum chamber 1. A plasma generation region 6 is defined between the anode 4 and the cathode 5.

The anode 4 is insulated from the chamber 1 by insulators 8 and 9 made of, e.g., Teflon and is grounded through a lead 10. The cathode 5 is supported by a supporting plate 7 so as to form a space 13 therebetween. A lead 14 connected to the cathode 5 extends from the space 13 through a vacuum seal 22 and is connected to a high-frequency power source 16 through an impedance matching circuit 15.

In order to radiate heat generated during etching, water cooling pipes 17 and 18 are respectively disposed on and below the anode 4 and the cathode 5.

Futhermore, the vacuum chamber 1 comprises an outlet port 19 having a relatively large diameter. A conductance valve 20 is arranged at the outlet port 19, for controlling the pressure in the vacuum chamber 1. An evacuating means (not shown) such as a diffusion pump, Roots pump, or rotary pump is arranged at a downstream side of the conductance valve 20.

In operation, a plurality of workpieces 23 having at least one III-V group compound semiconductor crystal layer are arranged on the cathode 5. Examples of such III-V Group compound semiconductor to be etched include GaAs, GaA$\ell$As, GaA$\ell$AsP, InA$\ell$GaP and the like. The dry etching method of the present invention is suitable for etching the III-V Group compound semiconductor containing an element such as aluminum which is easily oxidized.

The pressure in the vacuum chamber 1 is reduced by the evacuating means. The pressure reduced by this preevacuation is preferebly low. For example, after reducing the pressure in the vacuum chamber from 1 to 0.000006 Torr or less (from 133 to $8 \times 10^{-4}$ Pa), $BC\ell_3$ and $C\ell_2$ gases are respectively introduced from the inlet ports 2 and 3. The pressure of the introduced plasma-generating gas is controlled by the conductance valve 20. When anisotropic etching is performed, the total pressure of $BC\ell_3$ and $C\ell_2$ in the vacuum chamber 1 is preferably set to be 0.15 Torr or less (20 Pa or less), and particularly preferable to be 0.04 to 0.08 Torr (5.3 to 10.7 Pa). In order to achieve anisotropic etching, the proportion of the $C\ell_2$ gas in the introduced plasma-generating gas is set to be 40% by volume or less of the total volume of the plasma gas, and particularly preferable to be 20% by volume or less. This proportion can be easily achieved by controlling the flow rate of the $BC\ell_3$ and $C\ell_2$.

High-frequency electric power is applied to the anode 4 and the cathode 5, while they are cooled by the water cooling pipes 17 and 18. Then, glow discharge occurs between the anode 4 and the cathode 5 (i.e., in the plasma generation region 6), thereby generating a plasma from the introduced plasma-generating gas. An exposed compound semiconductor crystal layer of the workpiece 23 to be etched is etched by the thus generated plasma. An electric power density of the high-frequency electric power applied for generating a plasma is preferably set to be 0.1 W/cm$^2$ to 1 W/cm$^2$, and particularly preferable to be 0.3 W/cm$^2$ to 0.6 W/cm$^2$.

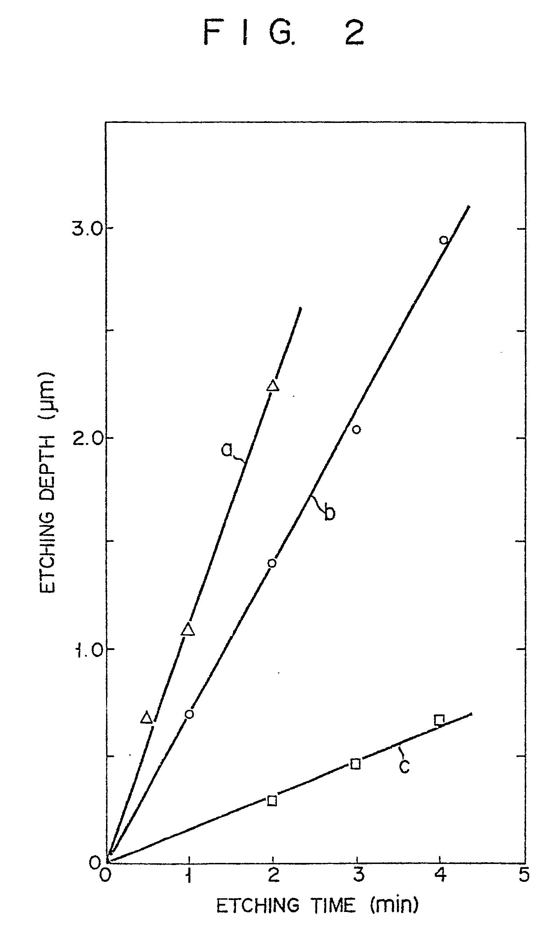

Fig. 2 shows the relationship between an etching time and an etching depth, etching rate, when GaAs is

5

etched by the dry etching method of the present invention. The etching conditions were as follows. The high-frequency electric power density was 0.42 W/cm², the flow rate of the $BCl_3$ introduced into the vacuum chamber 1 was 40 standard cubic centimeters (SCCM), and the flow rate of the introduced $Cl_2$ was 8 SCCM. Under these conditions, when the total pressure of the $BCl_3$ and $Cl_2$ gases was set at 0.15 Torr (20 Pa), the result indicated by the line a was obtained, and when the total pressure was set at 0.06 Torr (8 Pa), the result indicated by the line b was obtained. For the purpose of comparison, when only the $BCl_3$ gas was introduced (at a pressure of 0.06 Torr-8Pa-in the vacuum chamber), the result indicated by the line c was obtained. As is apparent from Fig. 2, in all cases, the etching time and the etching depth show a linear relationship, and etching was performed immediately without a time lag, thus achieving good reproducibility. When the $Cl_2$ gas was added to the $BCl_3$ gas, it was confirmed that etching was performed at an etching rate of five times that of the case wherein only the $BCl_3$ gas was used.

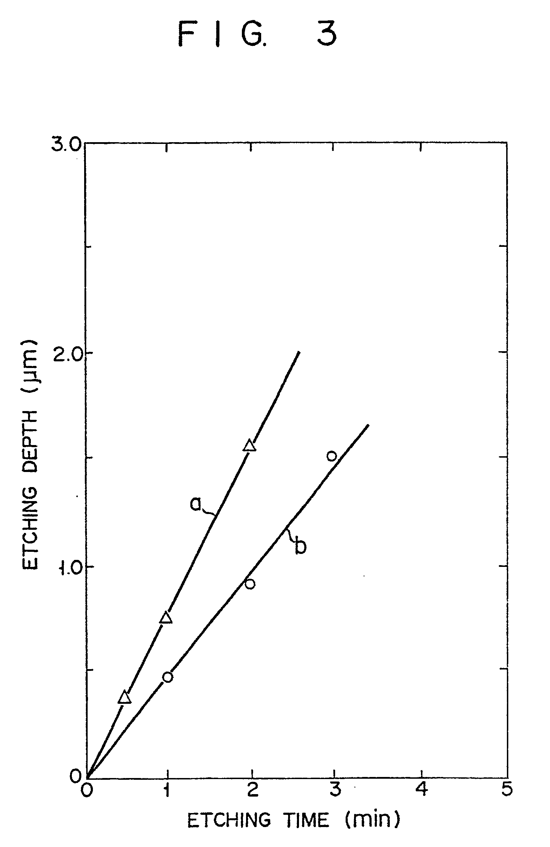

Fig. 3 shows the result when $Ga_{1-x}Al_xAs$ (x = 0.45) is etched under the same conditions as those of Fig. 2. The lines a and b indicate the results when the total pressure was set at 0.15 Torr (20 Pa) and at 0.06 Torr (8 Pa), respectively. In this case, the graph shows a satisfactory result, as in Fig. 2.

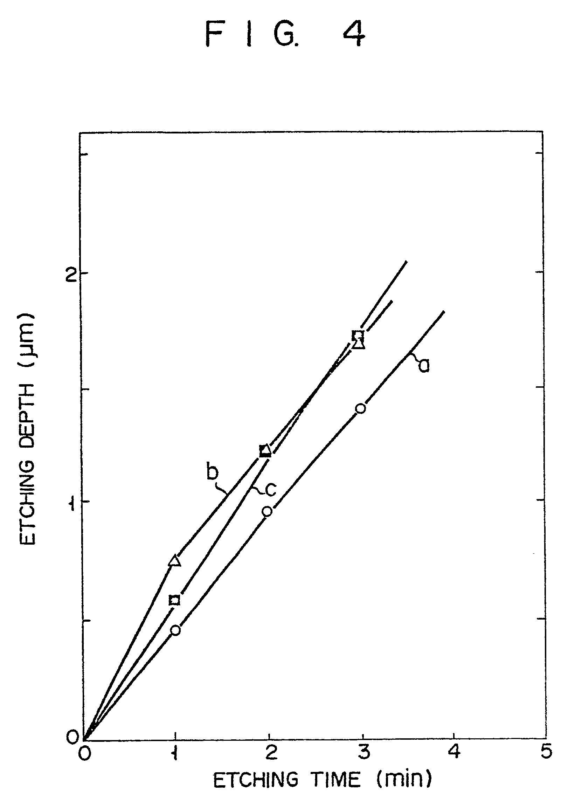

Fig. 4 shows the relationship between an etching time and an etching depth when a GaAs compound semiconductor is etched using dichlorodifluoromethane as a plasma-generating gas. A high-frequency electric power density was 0.42 W/cm². In Fig. 4, line a indicates the case wherein the gas flow rate was 10 SCCM and the pressure in the vacuum chamber was 0.04 Torr (5.3 Pa), line b indicates the case wherein a gas flow rate was 10 SCCM and pressure was 0.06 Torr (8 Pa), and line c indicates the case wherein the gas flow rate was 17 SCCM and the pressure was 0.06 Torr(8 Pa). As is apparent from Fig. 4, when dichlorodifluoromethane was used, linearity of the etching time and the etching rate became poor, resulting in a time lag before etching could be started. In addition, the variations in the etching rate suggest that a polymer is formed on the entire surface of the compound semiconductor.

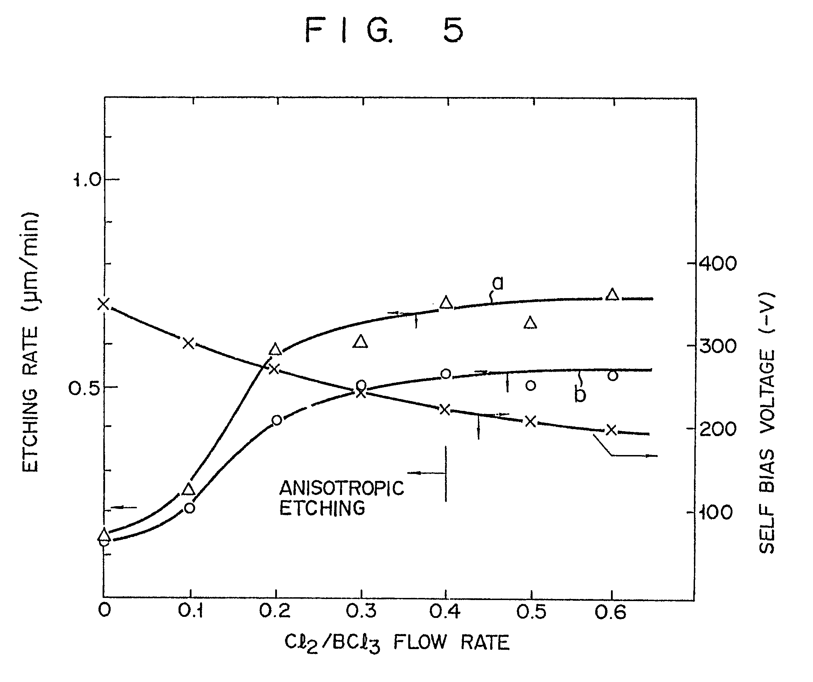

Fig. 5 shows the change in an etching rate when the flow rate of chlorine gas is changed under conditions wherein the high-frequency electric power density was 0.42 W/cm², the flow rate of $BCl_3$ in the vacuum chamber was 40 SCCM, and the total gas pressure was 0.06 Torr (8 Pa). Line a represents the result of the GaAs, and line b represents the result of the $Ga_{1-x}Al_xAs$ (x = 0.45). Note that Fig. 5 also shows a self-biasing value at the cathode. As is apparent from Fig. 5, when the flow rate ratio of $Cl_2$ with respect to $BCl_3$ is 0.1 or more, an etching rate becomes practical. When this ratio exceeds about 0.4, anisotropic etching cannot be achieved.

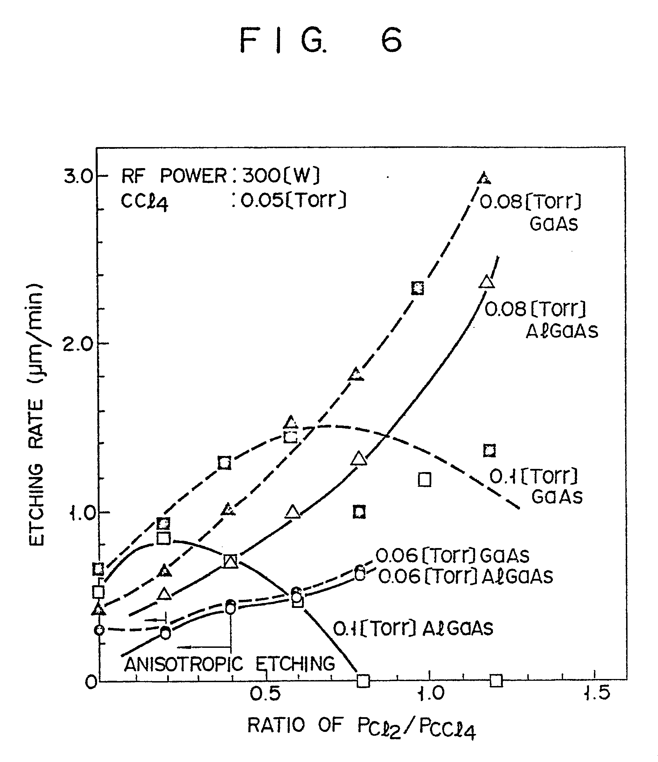

Fig. 6 shows a relationship between a partial pressure ratio of $Cl_2$ to $CCl_4$ when a compound semiconductor was etched by using a mixture of $Cl_2$ and $CCl_4$. Conditions were as shown in Fig. 5. When the mixture of $CCl_4$ and $Cl_2$ was used, conditions for anisotropically etching GaAs and GaAlAs at substantially the same etching rate are limited to a partial pressure ratio of $Cl_2$ and $CCl_4$ of less than 0.2. Even if the etching conditions were varied by a small amount, the etching rates of both the compound semiconductors became considerably different, resulting in these conditions being inconvenient for practical use.

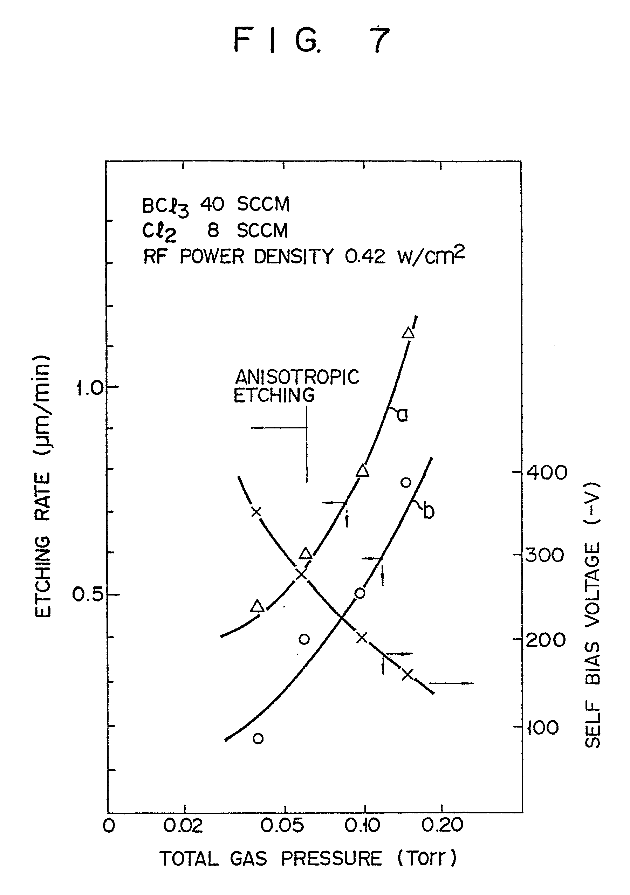

Fig. 7 shows a change in an etching rate corresponding to a change in the total pressure of $BCl_3$ and $Cl_2$ under conditions wherein the high-frequency electric power density was 0.42 W/cm², the flow rate of the $BCl_3$ introduced into the vacuum chamber was 40 SCCM, and the flow rate of the $Cl_2$ introduced thereinto was 8 SCCM. Line a represents the case wherein GaAs was etched, and line b represents the case wherein $Ga_{x-1}Al_xAs$ (x = 0.45) was etched. As is apparent from Fig. 7, the dry etching method of the present invention allows a wide range of a total gas pressures for etching a compound semiconductor. In addition, the gas pressure dependency of the etching rate of both GaAs and GaAlAs are substantially the same. Note that a total gas pressure for achieving anisotropic etching was 0.06 Torr (8 Pa) or less.

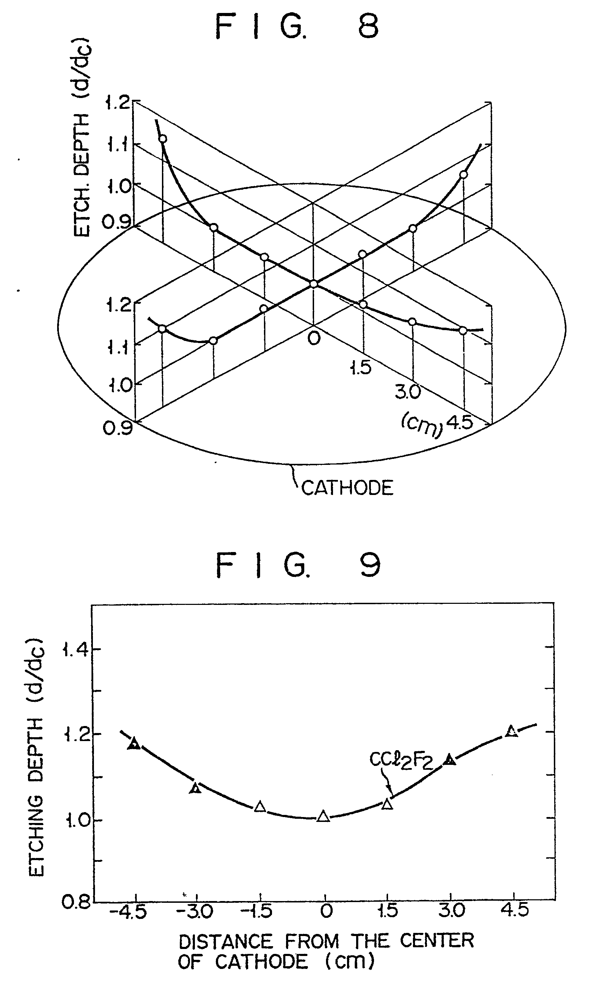

Fig. 8 shows a ratio of an etching depth with respect to the distance of a workpiece from the cathode center (i.e., etching depth/etching depth of the workpiece at the cathode center (1.38 μm) when a GaAs substrate (workpiece) arranged on the cathode having a diameter of 11 cm was etched. The GaAs substrate was etched under the conditions wherein the high-frequency electric power density was 0.42 W/cm², the introduction flow rate of the $BCl_3$ in the vacuum chamber was 8 SCCM, the total gas pressure was 0.06 Torr (8 Pa), the distance between the anode and the cathode was 6 cm, and the etching time was 2 minutes. The uniformity of the etching depth was ± 5% on the entire surface of the cathode and was ± 2% within 6 cm-regions from the cathode center. Therefore, considerably good etching uniformity can be obtained.

For the purpose of comparison, Fig. 9 shows the resulting uniformity under the same conditions as those of Fig. 8 when dichlorodifluoromethane was used as a plasma-generating gas. When Fig. 8 is compared with Fig. 9, the dry etching method of the present invention using a mixture of $BCl_3$ and $Cl_2$ as a plasma-generating gas shows better uniformity than that using dichlorodifluoromethane as a plasma-generating gas. When dichlorodifluoromethane was used, an etching depth depended greatly upon the distance from the cathode center of the workpiece.

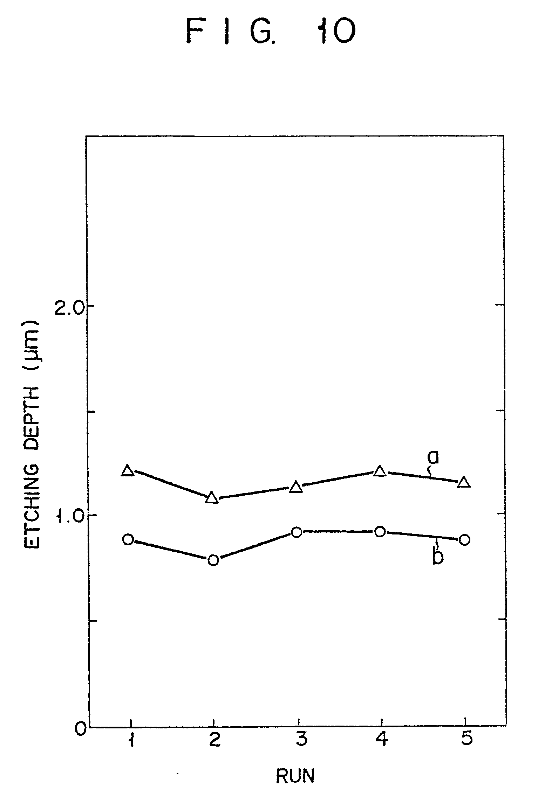

Fig. 10 shows the etching depth when GaAs and GaAℓAs were respectively etched five times under conditions wherein the high-frequency electric power density was 0.42 W/cm$^2$, the flow rate of BCℓ$_3$ introduced into the vacuum chamber was 40 SCCM, that of Cℓ$_2$ was 8 SCCM, the total gas pressure in the vacuum chamber was 0.06 Torr (8 Pa), and the etching time was 2 minutes. Line a represents the result of GaAs and line b represents that of GaAℓAs. The etching depth of GaAs was within 1.16 ± 0.10 μm, and that of GaAsAℓ was within 0.88 ± 0.09 μm. Therefore, very good reproducibility can be obtained.

Next, Table 1 shown below shows an etching rate (etching selectivity) of a compound semiconductor and a mask material when a compound semiconductor was selectively etched when masked by AZ-1350 (AZ positive-working photoresist available from Shiplay Company) or a silicon oxide film. For the purpose of comparison, the result using a gas mixture of CCℓ$_4$ and Cℓ$_2$ is also shown.

Table 1

| Material to be etched / Mask material | $BCℓ_3 + Cℓ_2$ (1) | | $CCℓ_4 + Cℓ_2$ (2) | |
|---|---|---|---|---|
| | GaAs | GaAℓAs | GaAs | GaAℓAs |
| AZ-1350 | 11 to 12 | 6 to 8 | 4.5 | 3.7 |
| $S_iO_2$ | 50 to 70 | 30 to 50 | 19 | 15 |

Note) Etching conditions:

(1) $BCℓ_3$: 40 SCCM

Cℓ$_2$: 8 SCCM

Total gas pressure: 0.06 Torr (8 Pa)

Rf power density: 0.42 W/cm$^2$

(2) $CCℓ_4$: 0.05 Torr (6.7 Pa)

Cℓ$_2$: 0.02 Torr (2.7 Pa)

Total gas pressure: 0.06 Torr (8 Pa)

Rf power density: 0.45 W/cm$^2$

A plurality of GaAℓAs layers are formed on a GaAs substrate so as to form a semiconductor laser, light-emitting diode, a photodiode or an integrated element thereof. In this case, the reactive ion etching method of the present invention can be effectively used. For example, in the case of a semiconductor laser, an end face of a resonator is conventionally formed by manual cleaving, and this process provides a considerably low productivity. However, when the reactive ion etching method of the present invention is used, a monolithic end face can be formed, thereby providing high productivity and high industrial value. Furthermore, in integrated elements including semiconductor lasers, the cleaving process cannot be adopted for forming the end face thereof. However, if the reactive ion etching method of the present invention is used, such integrated elements can easily be realized. On the other hand, the process for forming a mesa structure of a buried type laser or an inner stripe groove formed in a current blocking layer of an inner stripe type laser is important for lasing the laser in the transverser mode and for obtaining a beam which has high roundness. Currently, this process is performed by wet etching. However, it is difficult to control a 1 to 2 μm region by wet etching, resulting in poor reproducibility. In contrast, when formation of a mesa structure or groove is performed by using the reactive ion etching method of the present invention, control of a 1 to 2 $\mu$m region can be easily performed. In addition, since the method of the present invention is anisotropic etching, it can be effectively used to manufacture a device. Furthermore, the method of the present invention can be effectively adopted in a process for forming a substrate and a process for forming holes of a ballast type light emitting diode.

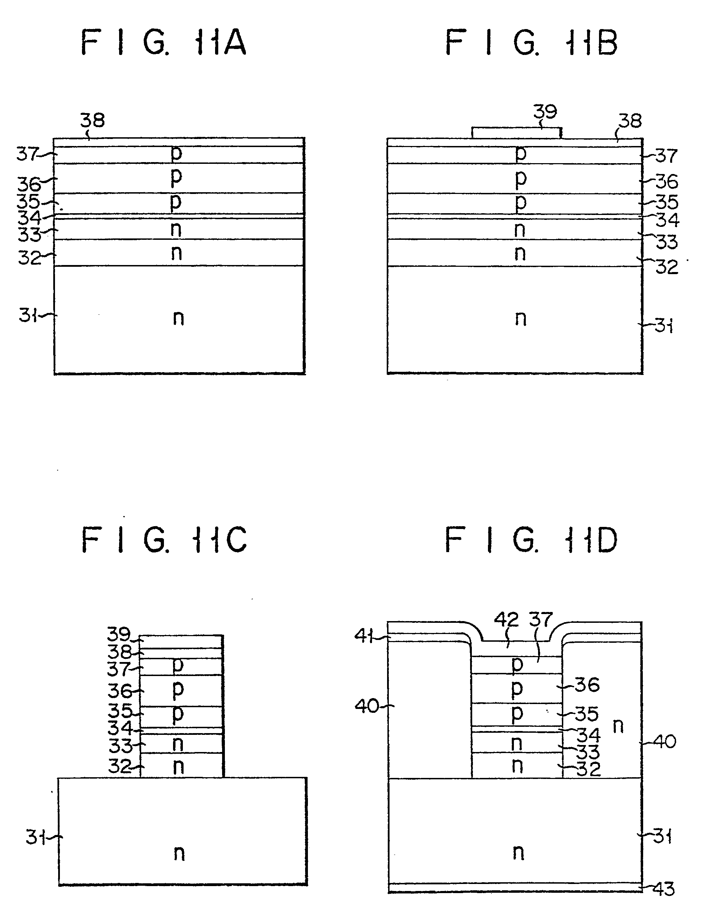

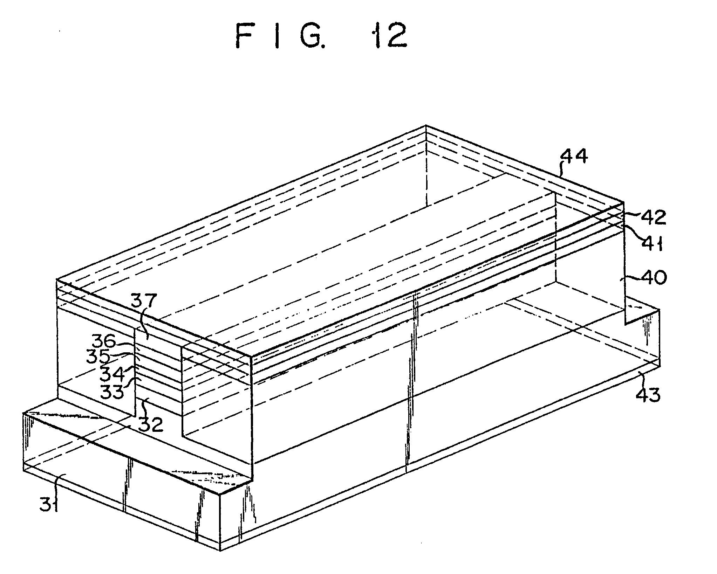

An example in which the dry etching method of the present invention is adopted for manufacturing a buried type semiconductor laser will now be described with reference to Figs. 11A to 11D and 12. As shown in Fig. 11A, an n-type $Ga_{0.65}Al_{0.35}As$ layer (cladding layer) 32, an n-type $Ga_{0.8}Al_{0.2}As$ layer (optical guiding layer) 33, a $Ga_{0.95}Al_{0.05}As$ layer (active layer) 34, a p-type $Ga_{0.8}Al_{0.2}As$ layer (optical guiding layer) 35, a p-type $Ga_{0.65}Al_{0.35}As$ layer (cladding layer) 36, a p-type GaAs layer 37 and a p-type $Ga_{0.4}Al_{0.6}As$ layer 38 are sequentially stacked on an n-type GaAs substrate 31. The thickness of this multilayer on the substrate 31 is about 5 $\mu$m. Then, as shown in Fig. 11B, a resist film is coated on a surface of the thus formed GaAlAs multilayer. The resist film is patterned to form a stripe-shaped resist pattern 39. The GaAlAs multilayer is selectively etched using the resist pattern 39 as a mask and the parallel plate type dry etching apparatus shown in Fig. 1. In this case, etching is performed under conditions wherein a gas mixture of $BCl_3$ and $Cl_2$ having a volume ratio of $Cl_2/BCl_3$ = 20% is used, the etching pressure and the high-frequency electric power density are respectively controlled to be 0.06 Torr (8 Pa) and 0.42 W/cm$^2$, thereby etching the GaAlAs multilayer down to the GaAs substrate 31, as shown in Fig. 11C.

As shown in Fig. 11D, the resist pattern 39 is removed. Buried layers 40 are selectively formed on the substrate 31 using the p-type $Ga_{0.4}Al_{0.6}As$ layer 38 as a selective crystal growth mask. Thereafter, the p-type $Ga_{0.4}Al_{0.6}As$ layer 38 is removed. Insulation layers 41 are formed on the buried layers 40. Then, an electrode 42 is formed on the GaAs layer 37, and another electrode 43 is formed on a lower surface of the GaAs substrate 31 by vacuum deposition.

Then, as shown in Fig. 12, a photoresist mask 44 is formed on the electrode 42 so as to cover a portion of a mesa region and the buried layers 40 and to have an end thereof perpendicular to a mesa stripe. Thereafter, the electrode 42 is etched by reactive ion etching using a reactive gas mainly consisting of $Cl_2$. Subsequently, the GaAlAs multilayer and the buried layers 40 are etched dawn to the GaAs substrate 31 by using a gas mixture of $BCl_3$ and $Cl_2$ gases under the same conditions as described above. In this case, under the above conditions, since anisotropic etching is performed, an end face of the resonator can be formed, thereby forming a plurality of buried type semiconductor lasers on a single substrate in a monolithic manner.

According to the present invention, differences in etched shapes due to differences in a crystal mixture ratio of Al can be prevented. The side surface of the mesa structure and the end face of the resonator become flat, and no side etching occurs. Under the above conditions, the etching selection ratio of the resist, GaAs and GaAlAs are as shown in Table 1, and this etching selection ratio can be satisfactorily adopted in deep etching to about 5 $\mu$m.

As described above, according to the present invention, a compound semiconductor including Al as a component element can be anisotropically etched by reactive ion etching to a depth of about 5 $\mu$m with a practical etching rate. In this case, the etching rate and the reproducibility of the etching shape are considerable, and no polymer is formed on an etched surface. Furthermore, a selection ratio with respect to a mask is greatly increased over that of a conventional method. Therefore, when this etching process is introduced into a manufacturing process of a compound semiconductor device, the productivity, reproducibility and ease of circuit design are satisfactorily improved over those of a conventional wet etching or dry etching method, and so the industrial value thereof is considerable.

## Claims

1. A method of fabricating a semiconductor laser, comprising the steps of:

   forming, on a GaAs substrate, a multilayer having a plurality of GaAlAs layers respectively having different contents of aluminium so as to provide a resonator structure;

   placing the resultant structure in a plasma generation region which is defined between a cathode and an anode opposite thereto;

   introducing a plasma-generating gas comprising boron trichloride and chlorine into the plasma generation region;

   applying high-frequency electric power between said cathode and said anode, thereby generating a plasma from said plasma generating gas; and

   forming an end face or faces of said resonator structure by dry etching the structure across the thickness thereof with said plasma, so as to prepare the semiconductor laser.

## EP 0 144 142 B1

2. A method according to claim 1, characterised in that the total gas pressure of the boron trichloride and the chlorine which are introduced in said plasma generation region (6) is not more than 20Pa (0.15 Torr).

3. A method according to claim 1, characterised in that said plasma gas contains not more than 40% by volume of chlorine.

4. A method according to claim 1, characterized in that the high-frequency electric power has a density of 0.1 W/cm$^2$ to 1 W/cm$^2$.

5. A method of fabricating a semiconductor laser comprising the steps of:

forming, on a substrate, a multilayer having a plurality of III-V Group compound semiconductor layers each containing aluminium and respectively having different contents of aluminium so as to provide a resonator structue;

placing the resultant structure in a plasma generation region which is defined between a cathode and an anode opposite thereto;

introducing a plasma-generating gas comprising boron trichloride and chlorine into the plasma generation region;

applying high-frequency electric power between said cathode and said anode, thereby generating a plasma from said plasma generating gas; and

forming an end face or faces of said resonator structure by dry etching the structure across the thickness thereof with said plasma, so as to prepare the semiconductor laser.

6. A method according to claim 5, characterised in that said compound semiconductor comprises GaAlInP.

7. A method according to claim 5 or 6, characterised in that said substrate comprises GaAs.

## Revendications

1. Procédé de fabrication d'un composé semi-conducteur comprenant les étapes de :

Fabriquer sur un substrat en GaAs, une structure multicouches comportant une pluralité de couches en GaAlAs, présentant respectivement des contenus différents en aluminium Al de façon à produire une structure de résonateur ;

Disposer la structure résultante dans une région de génération d'un plasma qui est définie entre une cathode et une anode opposées l'une à l'autre ;

Introduire un gaz générateur de plasma contenant du trichlorure de bore BCl$_3$ et du chlore Cl$_2$ dans la région de génération du plasma ;

Appliquer une puissance électrique haute fréquence entre ladite cathode et ladite anode de façon à générer un plasma par le gaz générateur de plasma ; et

former au moins une face d'extrêmité de ladite structure de résonateur par gravure sèche de la structure à travers son épaisseur avec le dit plasma, de façon à préparer ledit laser semi-conducteur.

2. Procédé selon la revendication 1, caractérisé en ce que la pression gazeuse totale du trichlorure de bore BCl$_3$ et du gaz chlorhydrique Cl$_2$ qui sont introduits dans ladite région de génération de plasma (6) est d'au plus 20 Pa (0,15 Torr).

3. Procédé selon la revendication 1, caractérisé en ce que ledit gaz plasma contient au plus 40% en volume de gaz chlorhydrique Cl$_2$.

4. Procédé selon la revendication 1, caractérisé en ce que la puissance électrique haute fréquence a une densité comprise entre 0,1 W/ cm$^2$ et 1 W/ cm$^2$.

5. Procédé de fabrication d'un laser semi-conducteur comprenant les étapes de :

Fabriquer sur un substrat une structure multicouche ayant une pluralité de couches d'un composé semi-conducteur du groupe III-V contenant chacun de l'aluminium et ayant respectivement des contenus différents en aluminium de façon à fournir une structure de résonateur ;

Disposer la structure résultante dans une région de génération d'un plasma qui est définie entre une cathode et une anode opposées une à l'autre ;

Introduire un gaz générateur de plasma comprenant un trichlorure de bore $BCl_3$ et du gaz chlorhydrique $Cl_2$ dans la région de génération de plasma ;

Appliquer une puissance électrique haute fréquence entre ladite cathode et ladite anode de façon à engendrer un plasma par ledit gaz générateur de plasma ; et

Fabriquer au moins une face d'extrêmité de ladite structure de résonateur par gravure sèche de la structure dans son épaisseur avec ledit plasma de façon à préparer le laser semi-conducteur.

6. Procédé selon la revendication 5, caractérisé en ce que ledit composé semi-conducteur comporte du GaAllnP.

7. Procédé selon la revendication 5 ou 6, caractérisé en ce que ledit substrat comporte du GaAs.

**Patentansprüche**

1. Verfahren zur Herstellung eines Halbleiterlasers, umfassend die folgenden Schritte:

auf einem GaAs-Substrat erfolgendes Ausbilden einer Mehrschichtanordnung mit einer Anzahl von GaAlAs-Schichten jeweils verschiedener Aluminiumgehalte zwecks Bildung einer Resonatorstruktur,

Einbringen der resultierenden Struktur in einen Plasmaerzeugungsbereich, der zwischen einer Kathode und einer gegenüberstehenden Anode festgelegt ist,

Einführen eines Plasmaerzeugungsgases aus Bortrichlorid und Chlor in den Plasmaerzeugungsbereich,

Anlegen eines elektrischen Hochfrequenzstroms zwischen Kathode und Anode, um damit aus dem Plasmaerzeugungsgas ein Plasma zu erzeugen, und

Ausbilden einer oder mehrerer Endfläche(n) der Resonatorstruktur durch Trockenätzung der Struktur über ihre Dicke mittels des Plasmas zwecks Fertigung des Halbleiterlasers.

2. Verfahren nach Anspruch 1, dadurch gekennzeichnet, daß der Gesamtgasdruck des Bortrichlorids und des Chlors, die in den Plasmaerzeugungsbereich (6) eingeführt werden, nicht mehr als 2 Pa (0,15 Torr) beträgt.

3. Verfahren nach Anspruch 1, dadurch gekennzeichnet, daß das Plasmagas nicht mehr als 40 Vol.-% Chlor enthält.

4. Verfahren nach Anspruch 1, dadurch gekennzeichnet, daß der elektrische Hochfrequenzstrom eine Dichte von 0,1 $W/cm^2$ bis 1 $W/cm^2$ aufweist.

5. Verfahren zur Herstellung eines Halbleiterlasers, umfassend die folgenden Schritte:

auf einem Substrat erfolgendes Ausbilden mehrerer Verbundhalbleiterschichten aus einer Verbindung der Gruppen III-V des Periodensystems, die jeweils Aluminium enthalten und verschiedene Aluminiumgehalte aufweisen, zwecks Bildung einer Resonatorstruktur,

Einbringen der resultierenden Struktur in einen Plasmaerzeugungsbereich, der zwischen einer Kathode und einer gegenüberstehenden Anode festgelegt ist,

Einführen eines Plasmaerzeugungsgases aus Bortrichlorid und Chlor in den Plasmaerzeugungsbereich,

Anlegen eines elektrischen Hochfrequenzstroms zwischen Kathode und Anode, um damit aus dem Plasmaerzeugungsgas ein Plasma zu erzeugen, und

Ausbilden einer oder mehrerer Endfläche(n) der Resonatorstruktur durch Trockenätzung der Struktur über ihre Dicke mittels des Plasmas zwecks Fertigung des Halbleiterlasers.

6. Verfahren nach Anspruch 5, dadurch gekennzeichnet, daß der Verbundhalbleiter aus GaAllnP besteht.

7. Verfahren nach Anspruch 5 oder 6, dadurch gekennzeichnet, daß das Substrat aus GaAs besteht.

# F I G. 1

# FIG. 2

# F I G. 3

# F I G. 4

F I G. 5

# F I G. 6

# F I G. 7

# F I G. 8

CATHODE

# F I G. 9

DISTANCE FROM THE CENTER
OF CATHODE (cm)

# F I G. 10

# F I G. 11A

# F I G. 11B

# F I G. 11C

# F I G. 11D

# F I G. 12

EP 0 144 142 B1